## Europäisches Patentamt
## European Patent Office
## Office européen des brevets

(19)

(11) Veröffentlichungsnummer: **0 203 518**
**B1**

(12) **EUROPÄISCHE PATENTSCHRIFT**

(45) Veröffentlichungstag der Patentschrift: **29.08.90**

(51) Int. Cl.⁵: **C 01 B 33/02**

(21) Anmeldenummer: **86106928.4**

(22) Anmeldetag: **22.05.86**

(54) **Verfahren zur Herstellung von Formkörpern aus Siliciumgranulat für die Erzeugung von Siliciumschmelzen.**

(30) Priorität: **24.05.85 DE 3518829**

(43) Veröffentlichungstag der Anmeldung:
**03.12.86 Patentblatt 86/49**

(45) Bekanntmachung des Hinweises auf die
Patenterteilung:
**29.08.90 Patentblatt 90/35**

(84) Benannte Vertragsstaaten:
**DE IT**

(56) Entgegenhaltungen:
**EP-A-0 055 372**
**EP-A-0 072 565**
**DE-A-2 745 247**
**DE-A-2 821 481**

(73) Patentinhaber: **HELIOTRONIC Forschungs- und Entwicklungsgesellschaft für Solarzellen-Grundstoffe mbH**
**Johannes-Hess-Strasse 24**
**D-8263 Burghausen (DE)**

(72) Erfinder: **Geissler, Joachim, Dipl.-Ing.**
**Rosenstrasse 24**
**D-8261 Stammham (DE)**
Erfinder: **Helmreich, Dieter, Dr.**
**Robert-Koch-Strasse 185**
**D-8263 Burghausen (DE)**
Erfinder: **Luptovits, Roland, Dipl.-Ing.**
**Watzmann-Strasse 5**
**D-8261 Emmerting (DE)**
Erfinder: **Semmler, Maximilian, Dr.**
**Bachstrasse 14**
**D-8263 Burghausen (DE)**
Erfinder: **Walter, Burkhard**
**Brucknerstrasse 1**
**D-8263 Burghausen (DE)**

Courier Press, Leamington Spa, England.

**Beschreibung**

Die Erfindung betrifft ein Verfahren zur Herstellung von Formkörpern aus Siliciumgranulat für die Erzeugung von Sliciumschmelzen.

Es ist bekannt, als Ausgangsmaterial für Siliciumschmelzen Silicium in Granulatform einzusetzen. Das Siliciumgranulat wird dabei in geeigneten Behältnissen bereitgestellt und durch Energiezufuhr, beispielsweise mittels Widerstands-, Induktions- oder Strahlungsheizung auf Schmelztemperatur gebracht und direkt in den schmelzflüssigen Zustand übergeführt. Auf diese Weise lassen sich zum Beispiel Siliciumschmelzen für das Tiegelziehen nach Czochralski (vgl. z. B. DE—OS 28 21 481 bzw. US—PS 43 30 362), für die Herstellung grob- bis einkristalliner Folien aus Silicium (vgl. DE—OS 31 32 776 bzw. US—PS 44 47 829), für das Ziehen von Siliciumbändern (vgl. z. B. DE—OS 30 49 376 bzw. US—PS 44 28 783) oder für das Gießen von Siliciumblöcken mit Kolumnarstruktur (vgl. z. B. DE—OS 27 45 247 bzw. US—PS 41 75 610) erzeugen.

Gegenüber dem gleichfalls möglichen Aufschmelzen von stückigem Material hat der Einsatz von Silicium in Granulatform eine Reihe von Vorteilen. So läßt sich Siliciumgranulat ohne großen apparativen Aufwand handhaben, transportieren, dosieren, oder chargieren, ggf. auch nachchargieren. Nachteilig ist der wegen der großen Oberfläche des Granulats hohe, auf der unvermeidlichen Oxidhaut der Partikel beruhende Sauerstoffgehalt. Daneben läßt sich das Auftreten von äußerst störenden Stäuben im Schmelzraum kaum vermeiden. Ferner kann es beim Zuchargieren in Siliciumschmelzen durch größere Brocken zu Spritzern und zu Störungen der Schmelze durch Schwingungen oder unzulässige Temperaturänderungen bis zu teilweisem Ausfrieren kommen.

Aufgabe der Erfindung war es daher, ein Verfahren anzugeben, nach welchem sich ausgehend von Siliciumgranulat ohne die genannten Nachteile Siliciumschmelzen erzeugen lassen.

Gelöst wird die Aufgabe durch ein Verfahren, welches dadurch gekennzeichnet ist, daß in eine Anschmelzzone chargierte, miteinander in Kontakt gebrachte Granulatkörner durch Energiezufuhr oberflächlich angeschmolzen und zu einem Verbundmaterial vereinigt werden, welches taktweise oder kontinuierlich aus der Anschmelzzone herausbewegt wird und dabei einen Verbundformkörper bildet, welcher in einem nachgeschalteten Prozeßschritt in an sich bekannter Weise zum Aufschmelzen gebracht wird.

Bei diesem Verfahren einsetzbares Siliciumgranulat fällt beispielsweise bei der Zerkleinerung von Formkörpern aus polykristallinem Silicium, z. B. Rohren oder Stäben, welche in bekannter Weise, z. B. durch Zersetzung von Chlorsilanen, wie Trichlorsilan auf erhitzten Trägerkörpern erhältlich sind, in großen Mengen an. Günstig wird Siliciumgranulat eingesetzt, dessen Korngröße im Bereich von 1—50 mm liegt, d. h., dessen Granulatkörner ein Sieb mit 50 mm lichter Maschenweite passieren, während sie von einem Sieb mit lichter Maschenweite unter 1 mm zurückgehalten werden. Bisweilen empfiehlt es sich, die geeignete Granulatfraktion in geeignete Unterfraktionen zu unterteilen, beispielsweise von 1—10, 10—20 und 20—50 mm, um durch gezielte Dosierung und Mischung dieser Unterfraktionen die für die Herstellung von Verbundmaterial endgültig gewünschte Korngrößenverteilung genau einstellen und zuverlässig einhalten zu können.

Die Reinheit des eingesetzten Siliciumgranulats richtet sich grundsätzlich nach dem jeweils vorgesehenen Produkt; so wird man beispielsweise bei Grundmaterial für die Herstellung von elektronischen Bauelementen in der Regel das Material nach strengeren Reinheitskriterien auswählen als bei der Herstellung von Solarzellengrundmaterial.

Die Anschmelzzone kann grundsätzlich innerhalb von Räumen vorgesehen werden, welche die Zufuhr und Aufnahme von Siliciumgranulat, die Einspeisung von Energie und die kontinuierliche oder taktweise Entnahme des sich aus dem durch Verbindung der Granulatkörner entstehenden Verbundmaterial aufbauenden Verbundformkörpers gestatten. Zweckmäßig wird die Geometrie der Begrenzungswände nach Maßgabe des gewünschten Querschnittes des Verbundformkörpers gestaltet. In der Regel wird man also Anschmelzzonen mit ringförmigem oder quadratischem bis rechteckigem bzw. trapezoidalem Querschnitt einsetzen, da als Verbundformkörper zumeist Rund- oder Vierkantstäbe angestrebt werden. Grundsätzlich sind jedoch auch andere, z. B. prismenartige Geometrien nicht ausgeschlossen.

Als Werkstoffe für die mit Siliciumgranulat in Kontakt kommenden Begrenzungswände der Anschmelzzone haben sich solche Materialien bewährt, die auch in Gegenwart von angeschmolzenem Siliciumgranulat mechanisch stabil gehalten werden können und eine Kontamination des Siliciumgranulates weitgehend ausschließen, also beispielsweise Siliciumcarbid oder insbesondere Silicium, z. B. auch reaktionsgebundenes Material gemäß DE—OS 32 63 276 oder der deutschen Anmeldung mit Aktenzeichen 34 40 346.9. Man kann jedoch auch nur die die Anschmelzzone begrenzenden Innenwände mit diesen Materialien auskleiden oder beschichten und die Außenwände aus anderen Werkstoffen, beispielsweise Kupfer oder Graphit fertigen. Wichtig ist auch eine ein Verschmelzen des angeschmolzenen Granulats mit den Wänden verhindernde Wandtemperatur, welche gegebenenfalls durch zusätzliche Kühlung der Wände, z. B. mit Hilfe eines durchströmenden Kühlmediums wie Wasser oder Kühlgas erreicht werden kann.

Die Zufuhr des Siliciumgranulates kann mit Hilfe der dem Fachmann geläufigen, zum Fördern und Dosieren von Feststoffen geeigneten Einrichtungen, z. B. Schüttelrinnen, Förderbändern oder Rotationsdosieren, geschehen. Vorzugsweise wird das Granulat aus einem Reservoir kontinuierlich in die Anschmelzzone überführt, obwohl grundsätzlich auch ein portionsweises Chargieren nicht ausgeschlossen ist.

Zur Einspeisung der zum oberflächlichen Anschmelzen der Granulatkörner benötigten Energie kommen zwar prinzipiell auch Methoden wie Widerstands- oder Induktionsheizung infrage. Bevorzugt wird jedoch die Energie mittels Energiestrahl, wie Laser- oder insbesondere Elektronenstrahl zugeführt. Diese Formen der Energiezufuhr erleichtern nämlich das oberflächliche Anschmelzen der Granulatkörner und beschleunigen so die Zersetzung der Oxidhaut der Körner und damit die Entfernung des störenden Sauerstoffs.

Die Wahl der Energiequelle beeinflußt auch die in der Anschmelzzone einzustellende, gegenüber Silicium inerte Arbeitsatmosphäre. Während bei Widerstands- oder Induktions- heizung auch eine Inertgasatmosphäre, z. B. Argon, infrage kommt, ist bei dem bevorzugten Einsatz von Energie-, insbesondere Elektronenstrahlung auf ein möglichst gutes Vakuum, vorteilhaft besser als etwa $10^{-2}$ mbar, vorzugsweise $10^{-3}$—$10^{-5}$ mbar zu achten.

Um in dem in der Anschmelzzone befindlichen Siliciumgranulat die unerwünschte Bildung von vollständig aufgeschmolzenen bzw. nicht angeschmolzenen Teilbereichen zu verhindern, ist eine möglichst gleichmäßige Verteilung der zugeführten Energie über seine freie Oberfläche zweckmäßig. Auch bei den bevorzugten Energie-, insbesondere Elektronenstrahlen, ist in der Regel durch entsprechende Einstellung und Dosierung anzustreben, daß die Energiezufuhr im Randbereich der Anschmelzzone die Granulatkörner noch oberflächlich zum Anschmelzen bringt, ohne sie im Zentrum vollständig aufzuschmelzen. Grundsätzlich braucht bei Energiezufuhr mittels Energie-, insbesondere Elektronenstrahlung die bestrahlte Fläche nicht gleich der gesamen freien Oberfläche des in der Anschmelzzone befindlichen Siliciumgranulats zu sein.

Im allgemeinen wird zum oberflächlichen Anschmelzen der Granulatkörner eine Energiemenge benötigt, die etwa 20—60% des Wertes beträgt, der zum vollständigen Aufschmelzen der entsprechenden Siliciummenge benötigt wird. (Dabei ist auch die zum Aufheizen von Umgebungs auf Schmelztemperatur sowie die zum Ausgleich von eventuell auftretenden Energieverlusten, z. B in Folge von Wärmestrahlung erforderliche Energiemenge zu berücksichtigen). Aus der pro Zeiteinheit zugeführten Siliciumgranulatmenge kann damit überschlagsmäßig die pro Zeiteinheit einzuspeisende Energiemenge ermittelt werden. Vielfach hat es sich bewährt, in der Anfangsphase eine gegenüber diesem Wert erhöhte Energiemenge, gegebenenfalls sogar den 60%-Grenzwert überschreitende Energiemenge einzuspeisen und später zu reduzieren, wenn die Verbindung der Granulatkörner zuverlässig in Gang gekommen ist. Zweckmäßig wird innerhalb des vorgegebenen Bereiches der jeweils am besten geeignete Energiewert anhand von Vorversuchen empirisch ermittelt, bei dem eine zur Verbindung der Granulatkörner ausreichende Schmelzmenge vorhanden ist, die aber andererseits nicht so groß ist, daß die Gefahr des Auslaufens der Schmelze besteht.

Die in die Anschmelzzone chargierten Granulatkörner liegen dort entsprechend ihrer Schüttung zunächst in lockerem Kontakt miteinander, aber noch ohne Bindung aneinander vor. Sobald durch die Wirkung der zugeführten Energie einige Körner oberflächlich anzuschmelzen beginnen, setzt über Benetzung die Verbindung mit benachbarten Körnern ein und schreitet mit steigender Zahl oberflächlich angeschmolzener Körner immer weiter fort, bis ein zusammenhängendes, aber noch poröses Verbundmaterial entstanden ist. In dieser Phase ist in der Regel die Mehrzahl der in der Anschmelzzone befindlichen Körner ganz oder zumindest teilweise von einer geschmolzenen Schicht überzogen. Verläßt das solchermaßen angeschmolzene Verbundmaterial nun die Anschmelzzone, so erstarren die aufgeschmolzenen Bereiche der Granulatkorner wieder und das Material verfestigt sich zu einem stabilen, porösen Verbundformkörper.

Während bei seinem Durchgang durch die Anschmelzzone das frisch zuchargierte Granulat im Randbereich auch in Kontakt mit der Begrenzungswandung der Anschmelzzone kommt, kontrahiert sich beim Anschmelzen und Zusammenwachsen der Körner das Material geringfügig, so daß in diesem Stadium praktisch kein Kontakt mehr zwischen Granulat und Begrenzungswandung festzustellen ist. Uberraschend wurde gefunden, daß auch beim anschließenden Erstarren trotz der bei Silicium bekanntlich auftretenden Volumenvergrößerung von etwa 10% kein Kontakt mehr mit der Begrenzungswandung zustande kommt, so daß der gebildete Verbundformkörper problemlos aus der Anschmelzzone herausbewegt werden kann.

Es ist daher möglich, den Prozeß bei geeigneter Abstimmung der Menge des in die Anschmelzzone chargierten und des daraus abgezogenen verbundenen Materials kontinuierlich oder semikontinuierlich durchzuführen. Auf diese Weise lassen sich insbesondere die für ein späteres vollständiges Aufschmelzen bevorzugt eingesetzten Stäbe mit rundem oder rechteckigem bis quadratischem Querschnitt, grundsätzlich in beliebiger Länge, erhalten.

Gegenüber dem vorgelegten Siliciumgranulat besitzt der erhaltene Verbundformkörper eine erhöhte Dichte. Erfahrungsgemäß läßt sich bereits durch eine Dichteerhöhung um etwa 20%, bezogen auf die Schüttdichte des Ausgangsmaterials, eine ausreichende mechanische und thermische Stabilität des Verbundformkörpers erreichen. Andererseits sollte seine Dichte vorzugsweise unterhalb 1,86 g/cm$^3$ liegen, also nicht mehr als 80% der Dirchte von massivem Silicium betragen, da oberhalb dieses Wertes die Porosität meist nicht mehr ausreicht, um mechanische oder thermische Spannungen ohne die Bildung von Rissen oder Ausbrüchen auszugleichen. Die Dichte des erhaltenen Materials läßt sich vor allem über die Schüttdichte des Ausgangsmaterials, die zugeführte Energiemenge und die Durchlaufgeschwindigkeit des Materials durch die Anschmelzzone steuern.

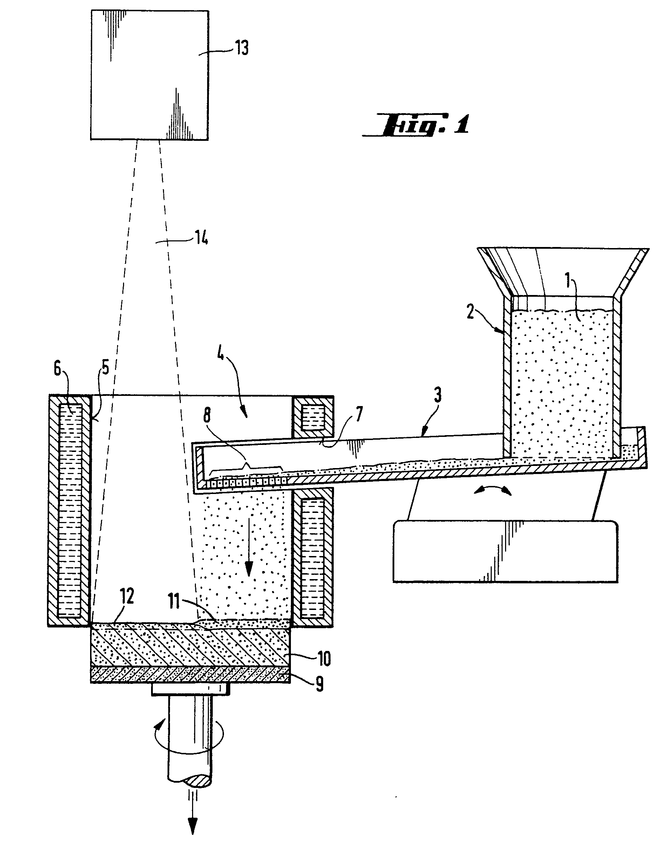

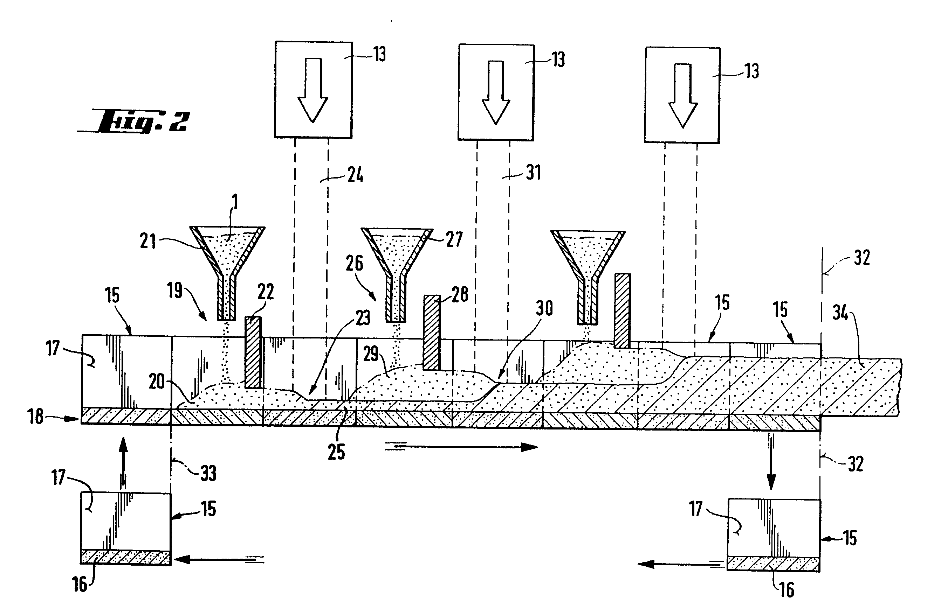

Im folgenden wird das erfindungsgemäße Verfahren durch die anhand der Fig. 1 und 2 dargestellten möglichen Ausführungsformen beispielhaft näher erläutert.

Fig. 1 zeigt modellhaft eine mögliche Ausgestaltung, in der sich semikontinuierlich Verbundformkörper in Form von Rundstäben herstellen lassen.

Fig. 2 stellt beispielhaft eine mögliche Ausgestaltung zur kontinuierlichen Herstellung von Verbundformkörpern mit trapezförmigem bzw. rechteckigem bis quadratischem Querschnitt dar.

Gemäß der in Fig. 1 dargestellten Anordnung wird gegebenenfalls beispielsweise durch Säurebehandlung gereinigtes und in der gewünschten Korngröße vorliegendes Siliciumgranulat 1 in einer Granulatkammer 2 bereitgestellt, aus welcher es mittels einer Schüttelrinne 3 in eine Anschmelzkammer 4 dosiert wird.

Die Anschmelzkammer 4 besteht aus einem z. B. aus Kupfer gefertigten, an der Innenseite mit beispielsweise Silicium beschichteten Leitring 5, welcher in seinem Inneren Kanäle 6 besitzt, durch die ein Kühlmittel wie Wasser oder Kühlgas geleitet werden kann. Durch eine Öffnung 7 ragt die Schüttelrinne 3 radial in das Innere der Anschmelzkammer 4, zweckmäßig auf einer 65—90% des Kammerradius entsprechenden Strecke, und gibt auf dieser Chargierstrecke 8 kontinuierlich die herantransportierten Granulatkörner frei. Diese rieseln nach unten und lagern sich auf der Oberfläche eines zweckmäßig mit etwa 10—60 Umdrehungen pro Minute rotierenden, auf einem aus hochtemperaturfestem Material, wie Silicium oder Siliciumcarbid gefertigten, dreh- und absenkbaren Stempel 9 aufliegenden, aus bereits verbundenem Granulat bestehenden Verbundformkörperabschnitt 10, so ab, daß eine gleichmäßige Schütthöhe über die Sektorfläche erzielt wird. Aufgrund der Drehbewegung gelangt das auf dessen Oberfläche aufgebrachte Granulat 11 dann in die eigentliche Anschmelzzone 12, einen von einem aus einer Strahlungsquelle 13 stammenden Energie-, vorzugsweise Elektronenstrahl 14 bestrahlten Bereich auf der Oberfläche des rotierenden Verbundformkörperabschnittes 10. Zweckmäßig wird dieser Bereich so groß gewählt, daß nur etwa 50—70% der gesamten Stirnfläche des Verbundformkörperabschnittes der Strahlung ausgesetzt sind.

Selbstverständlich sind auch Anordnungen denkbar, in denen der Strahl nicht nur auf Teilbereiche, sondern auf die gesamte freie Stirnfläche des Granulates einwirkt. Auch andere Methoden des Granulatchargierens, z. B. mittels Rotationsdosierer, oder andere Ausgestaltungen der Anschmelzkammer, z. B. durch abgeschrägte Innenwände, oder eine andere Ausbildung der Anschmelzzone, z. B. in trichterartig zur Mitte hin abgesenkter Form, sind grundsätzlich nicht ausgeschlossen.

In der Anschmelzzone 12 werden die zuchargierten Granulatkörner mit Hilfe der eingestrahlten Energie oberflächlich angeschmolzen; einander benachbarte Körner verbinden sich dadurch sowohl untereinander als auch mit dem bereits erzeugten darunter liegenden Verbundmaterial. Beim Verlassen des bestrahlten Bereiches wird durch zuchargiertes Granulat eine Granulatschicht erzeugt, welche dem bedeckten Verbundmaterial Wärme entzieht, seine Kristallisation beschleunigt, und dabei selbst auf eine erhöhte Temperatur gebracht wird. Dadurch stabilisiert sich die Bindung der beschichteten Granulatkörner untereinander und zur Unterlage.

Beim Durchgang durch den Strahlengang wird nun die neu aufgebrachte Granulatschicht analog angeschmolzen und verbunden. Auf diese Weise wächst der Verbundformkörper mit fortschreitender Granulatzufuhr. Wird der rotierende Stempel entsprechend dieser Wachstumsgeschwindigkeit abgesenkt, so verbleibt die Anschmelzzone innerhalb dieser Anschmelzkammer stets im wesentlichen auf derselben Höhe. Dadurch kann auch verhindert werden, daß die oberste Wachstumskante zu weit in die Anschmelzkammer hineinwächst und dadurch gegebenenfalls die Drehung behindert.

Wenn der Verbundformkörper die gewünschte Höhe erreicht hat, wird die Granulat- und Energiezufuhr gestoppt, und der erhaltene Rundstab kann entnommen und an den gewünschten Einsatzort gebracht werden, um dann endgültig aufgeschmolzen zu werden. Derartige Rundstäbe werden häufig mit etwa 50—150 mm Durchmesser und 200—400 mm Höhe hergestellt; diese Angaben sind jedoch nur beispielhaft, nicht aber im Sinne einer Beschränkung zu verstehen.

Wenn die solcherart erhaltenen Rundstäbe vor dem endgültigen Aufschmelzen zu größeren Stabeinheiten zusammengefügt, beispielsweise verschmolzen werden sollen, hat es sich oftmals bewährt, in ihren Stirn- und Basisflächen paßgerechte Fortsätze bzw. Ausnehmungen vorzusehen, beispielsweise Zapfen und Zapfenloch oder dergleichen, um die erneute Verbindung zu erleichtern. Diese Vorgehensweise empfiehlt sich insbesondere dann, wenn bei semikontinuierlicher Herstellung der Teilstäbe das endgültige Aufschmelzen kontinuierlich vorgenommen werden soll.

Die in der Fig. 1 dargestellte Anordnung ist von einem aus Gründen der Übersichtlichkeit nicht gezeigten Rezipienten, beispielsweise aus Edelstahl umgeben, der es gestattet, die entsprechende Arbeitsatmosphäre einzustellen und aufrechtzuerhalten. Als vorteilhaft hat sich insbesondere ein Vakuum von $10^{-3}$—$10^{-5}$ mbar erwiesen, bei dem sich der unvermeidliche, hauptsächlich durch die Herstellung und Lagerung des Granulates an Luft verursachte hohe Sauerstoffgehalt deutlich erniedrigen läßt. Beim Anschmelzen wird nämlich die die Granulatkörner überziehende Oxidhaut zerstört, und der Sauerstoff kann in Form von flüchtigem Siliciummonoxid abdampfen.

Gemäß der in Fig. 2 schematisch dargestellten Anordnung kann der bei dem erfindungsgemäßen Verfahren entstehende Verbundformkörper nicht nur, wie in Fig. 1 gezeigt, im wesentlichen parallel zur Chargierrichtung des Siliciumgranulates aus der Anschmelzzone herausbewegt werden, also im wesentlichen vertikal, sondern auch im wesentlichen senkrecht dazu, also im wesentlichen horizontal. Dieses Verfahren eignet sich insbesondere für einen schichtweisen Aufbau des Verbundformkörpers durch mehrere hintereinander geschaltete Chargier- und Anschmelzschritte.

Zur Aufnahme des zuchargierten Siliciumgranulates eignen sich beispielsweise in Längsrichtung offene, trogartige, z. B. aus Graphit oder Silicium gefertigte Formelemente 15, bei welchen die Bodenfläche 16 und die beiden Seitenwände 17 so ausgebildet sind, daß sie paßgerecht zu einer Förderstraße 18 aneinandergereiht werden können. Der Troginnenraum kann dabei z. B. einen rechteckigen, quadratischen, oder günstig trapezartig nach oben sich erweiternden Querschnitt aufweisen. Er ist vorteilhaft mit Materialien wie Silicium oder Siliciumcarbid beschichtet oder ausgekleidet. Die in die Förderstraße 18 eingereihten Formelemente 15 bewegen sich zunächst auf eine erste Chargierstation 19 zu, wo sie eine erste Granulatschicht 20 von aus einer Dosiereinrichtung 21 freigegebenem Siliciumgranulat 1 aufnehmen. Gegebenenfalls kann diese Granulatschicht 20 mit Hilfe eines Abstreifers 22 vergleichmäßigt werden, ehe sie anschließend in einer ersten Anschmelzzone 23, z. B. vermittels eines Elektronenstrahls 24, oberflächlich angeschmolzen und zu einer Verbundschicht 25 vereinigt werden kann. Diese gelangt während oder nach dem Erstarren in eine nächste Chargierstation 26 mit Dosiereinrichtung 27 und gegebenenfalls Abstreifer 28, wo sie mit einer weiteren Granulatschicht 29 überschichtet wird. Diese wird anschließend in einer Anschmelzstation 30, z. B. mittels eines Elektronenstrahls 31, in analoger Weise durch oberflächliches Anschmelzen der Granulatkörner verfestigt und zugleich mit der unteren, bereits vorhandenen Verbundschicht 25 verbunden.

Dieser Vorgang mit Chargieren, gegebenenfalls Egalisieren, anschließendem oberflächem Anschmelzen, Verbinden und Erstarren der Granulatkörner kann so oft wiederholt werden, bis der gewünschte Füllungsgrad der Förderstraße 18 und damit die gewünschte Form des Verbundformkörpers erreicht ist. Aus dieser Endposition 32 können die Formelemente 15 schließlich abgesenkt, wieder in die Ausgangsposition 33 zurückgeführt und erneut in die Förderstraße 18 eingereiht werden. Der kontinuierlich erhaltene stabförmige Verbundformkörper 34 kann dann beispielsweise in eine hier nicht dargestellte Anschmelzstation eingeführt und von seinem Ende her aufgeschmolzen werden. Die solchermaßen kontinuierlich erhältliche Siliciumschmelze kann mit besonderem Vorteil bei der Herstellung von grob- bis einkristallinen Siliciumfolien gemäß DE—OS 31 32 776 bzw. US—PS-4 447 289 eingesetzt werden.

Grundsätzlich sind auch z. B. Anordnungen möglich, bei denen nicht die gesamten Formelemente 15 beweglich gestaltet sind, sondern in denen bei ortsfesten Seitenwänden lediglich die Bodenflächen in der Art eines Förderbandes weiterbewegt werden. Gleichfalls denkbar sind z. B. Vorrichtungen, in denen ein beispielsweise trogartiges Förderelement wiederholt schichtweise beladen und von einer Aufschmelzzone durchlaufen wird.

Vielfach hat es sich bewährt, für die erste Chargierstation eine Siliciumgranulatfraktion mit geringer Korngröße, beispielsweise 1—10 mm, vorzusehen und die Korngröße bei den folgenden Chargierstationen zu steigern, so daß die Granulatkörner mit höheren Korngrößen, z. B. 20—50 mm, erst gegen Ende des Herstellungsvorganges zuchargiert werden.

Im allgemeinen ist in der ersten Anschmelzstation eine vergleichsweise größere Energiemenge zum oberflächlichen Anschmelzen des zuchargierten Siliciumgranulates erforderlich, als in den folgenden, in welchen dem jeweils zuchargierten Material bereits durch das vorher angeschmolzene und bereits verbundene Granulat Energie zugeführt wird. Die jeweils am besten geeignete zuzuführende Energiemenge wird, nach Maßgabe der Dosiergeschwindigkeit des Granulates, zweckmäßig innerhalb des Bereiches von 20 bis 60% des zum vollständigen Aufschmelzen der entsprechenden Granulatmenge erforderlichen Energiequantums empirisch anhand von Vorversuchen ermittelt.

Anstelle der in Fig. 2 gezeigten Anordnung mit jeweils einer Strahlungsquelle pro Anschmelzstation sind auch Ausführungsformen denkbar, in denen eine verstellbare Strahlungsquelle mehrere Anschmelzstationen versorgt.

Zur Erzeugung einer geeigneten Arbeitsatmosphäre ist die gesamte Anordnung in einem aus Gründen der Klarheit nicht dargestellten Rezipienten untergebracht. Vorteilhaft wird ein Vakuum von $10^{-3}$—$10^{-5}$ mbar eingestellt, um, wie bereits erläutert, den Sauerstoffgehalt des erhaltenen Verbundformkörpers gering zu halten.

Das erfindungsgemäße Verfahren zum Aufschmelzen von Siliciumgranulat, bei dem vor dem eigentlichen Schmelzschritt aus dem Granulat zunächst ein Verbundformkörper gebildet wird, eignet sich in besonderem Maße für Anwendungen, bei denen über lange Zeit ein kontinuierlicher Fluß von geschmolzenem Silicium benötigt wird, wie z. B. bei der bereits genannten Herstellung von Folien oder Bändern aus Silicium. Daneben ist der Einsatz von rundstabförmigen Vorformkörpern als Vorratsstab beim Zonenziehen denkbar. Weitere Anwendungsmöglichkeiten ergeben sich, wie eingangs erwähnt, beispielsweise beim Tiegelziehen nach Czochralski und beim Gießen von Siliciumblöcken mit Kolumnarstruktur. Bei diesen Verfahren können dann für das endgültige Aufschmelzen die bekannten und dem Fachmann geläufigen, z. B. für das Schmelzen von mono- oder polykristallinen Siliciumstäben angewandten Schmelzmethoden eingesetzt werden, also beispielsweise Aufschmelzen mittels Widerstands-, Induktions-, oder Strahlungsheizung.

In den nachfolgenden Ausführungsbeispielen, die nicht im Sinne einer Beschränkung zu sehen sind, wird die Erfindung näher erläutert:

### Beispiel 1

In einer der Fig. 1 entsprechenden Anordnung wurde eine Menge von 1,2 kg durch Säurebehandlung gereinigtes Siliciumgranulat (Korngröße 1—15 mm, Schüttdichte ca. 1 g/cm$^3$, Sauerstoffgehalt $> 10^{18}$ Atome/cm$^3$) bereitgestellt und über eine Schüttelrinne bei Bedarf in die Anschmelzkammer chargiert. Diese bestand aus einem wassergekühlten, an der Innenseite mit Siliciumcarbid beschichteten Kupferring (Innendurchmesser ca. 80 mm, Seitenhöhe ca. 50 mm), der an seiner Unterseite von einem dreh- und absenkbaren Stempel aus Siliciumcarbid abgeschlossen war. Von der offenen Oberseite her konnten aus einer Elektronenstrahlkanone etwa 60% der Stempeloberfläche mit einem Elektronenstrahl bestrahlt werden. Im System lag ein Vakuum von etwa 10$^{-4}$ mbar vor.

Durch Strahlablenksteuerung konnte die Energieverteilung des Elektronenstrahls so eingestellt werden, daß bei Drehung des Stempels die auf jedes Flächenelement während seines Durchlaufs durch den Strahlengang eingestrahlte Energiemenge annähernd gleich groß war. Damit war auch ein annähernd gleiches Anschmelzverhalten von der Mitte bis zum Rand des auf der in Drehung befindlichen Stempel chargierten Siliciumgranulates gewährleistet.

Zur eigentlichen Herstellung des Vorformkörpers wurde zunächst der Stempel in eine Dreh- und Absenkbewegung (etwa 12 Umdrehungen pro Minute Absenkgeschwindigkeit ca. 2 mm/sec) versetzt und mit Siliciumgranulat (Schüttgeschwindigkeit etwa 10 g/sec) beladen, bis eine Schütthöhe von ca. 10 mm erreicht war. Nun wurde der Elektronenstrahl eingeschaltet, und der Anschmelzvorgang begann. Dabei betrug die eingestrahlte Leistung während der ersten Umdrehung ca. 17 kW; sie wurde dann allmählich auf einen Wert von ca. 12 kW, entsprechend etwa 30% der zum vollständigen Aufschmelzen des Siliciumgranulates erforderlichen Leistung, heruntergefahren.

Die Energiezufuhr bewirkte, daß sich auf den einzelnen Granulatkörnern oberflächlich zumindest teilweise schichtartige Bereiche aus aufgeschmolzenem Silicium bildeten, welche allmählich im Kontaktbereich mit benachbarten Granulatkörnern verschmolzen. Dadurch entstand letztendlich eine von vielen Hohlräumen durchzogene Raumstruktur aus miteinander in Teilbereichen verbundenen Körnern, welche durch die Drehbewegung und gleichzeitiges Überschichten mit frisch zuchargiertem Granulat dem Einwirkungsbereich des Elekronenstrahls entzogen und dadurch abgekühlt und zum Erstarren gebracht wurden. Die Absenkungsgeschwindigkeit des rotierenden Stempels und damit des erhaltenen Verbundmaterials wurde mit etwa 2 mm/sec so eingestellt, daß die Anschmelzzone, d. h. die Zone, in welcher das Material in angeschmolzenen Zustand vorliegt, stets im unteren Endbereich des Leitringes verblieb, so daß sich die Wachstumskante weder zu weit ins Innere der Anschmelzkammer vorschob, noch aus dieser herauswanderte.

Nach etwa 2 Minuten hatte der gebildete Verbundformkörper eine Länge von ca. 200 mm erreicht; die Granulatzugabe wurde gestoppt und der Elektronenstrahl abgeschaltet. Der erhaltene Rundstab (Dichte etwa 1,3 g/cm$^3$, Sauerstoffgehalt $< 10^{17}$ Atome/cm$^3$) ließ sich dank seiner porösen Struktur ohne Gefahr des Zerplatzens aufgrund thermischer Spannungen entnehmen und in den Schmelzbereich einer Anlage zur Herstellung grob- bis einkristalliner Folien aus Silicium (gemäß US—PS-4 447 289) überführen, wo er schließlich mittels Elektronenstrahl von einem Ende her nach und nach vollständig aufgeschmolzen wurde.

Der Stempel wurde in die Ausgangsposition zurückgefahren, so daß zur Erzeugung eines weiteren Rundstabes erneut Siliciumgranulat in die Anschmelzkammer chargiert werden konnte.

### Beispiel 2

Diese Beispiel zeigt, in Anlehnung an die im Zusammenhang mit Fig. 2 erläuterte Vorgehensweise, die schichtweise Herstellung eines Vorformkörpers, der rechteckigen Querschnitt besitzt und jeweils in horizontaler Richtung aus der Anschmelzzone herausbewegt wird.

In einem auf 10$^{-4}$ mbar evakuierten Rezipienten wurde in einen aus Silicium gefertigten Trog mit den Innenmaßen 200·80·50 mm$^3$ aus einer Chargierstation eine etwa 10 mm hohe Schicht aus Siliciumgranulat der Korngröße 5—15 mm (Schüttdichte ca. 1 g/cm$^3$) chargiert.

Nun wurde mittels einer Elektronenstrahlkanone eine 80.20 mm$^2$ große Teilfläche des Troginhaltes bestrahlt, bis das Granulat zum oberflächlichen Anschmelzen gebracht war. Mit Beginn der Bestrahlung wurde der Trog in eine horizontale Linearbewegung von ca. 12 mm/sec versetzt, so daß bei konstanter Position des Elektronenstrahls die Anschmelzzone allmählich den gesamten Troginhalt durchwanderte. Die Leistung des Elektronenstrahles betrug dabei 16 kW.

Während dieses ersten Durchlaufes wurde unmittelbar auf den aus der Anschmelzzone austretenden, oberflächlich angeschmolzenen und sich zu einem Verbundmaterial verfestigenden Troginhalt eine weitere, etwa 10 mm dicke Granulatschicht derselben Körnung aufchargiert. Nach Ende des ersten Durchlaufes wurde auch diese zweite Schicht durch Relativbewegung zwischen Trog, Elektronenstrahl und Chargierstation von der Anschmelzzone durchlaufen und im Anschluß an den Anschmelzvorgang mit einer weiteren ca. 10 mm dicken Granulatschicht überschichtet. Dabei verband sich das Granulat mit der zweiten Schicht untereinander sowie mit dem darunter liegenden, bereits im ersten Durchgang verbundenen Material und heizte zugleich die dritte Schicht vor. Die Leistung des Elektronenstrahls ließ sich dabei auf 12 kW reduzieren.

Der Vorgang wurde wiederholt, bis im Trog nach einem abschließenden Durchlauf der Anschmelzzone ohne weiteres Nachchargieren von Granulat ein quaderförmiger Verbundformkörper (Maße 200.80.40 mm³, Dichte 1,3 g/cm³, Sauerstoffgehalt unterhalb der Nachweisgrenze von $10^{17}$ Atome/cm³) vorlag, der sich ohne Schwierigkeiten entnehmen ließ.

Der erhaltene Verbundformkörper konnte mittels Elektronenstrahl von einem Ende her vollständig aufgeschmolzen werden, wobei sich ohne Abplatzen von Bruchstücken ein ungestörter, gleichmäßiger Schmelzfluß ergab.

## Patentansprüche

1. Verfahren zur Herstellung von Formkörpern aus Siliciumgranulat für die Erzeugung von Siliciumschmelzen, dadurch gekennzeichnet, daß in eine Anschmelzzone chargierte, miteinander in Kontakt gebrachte Granulatkörner durch Energiezufuhr oberflächlich angeschmolzen und zu einem Verbundmaterial vereinigt werden, welches taktweise oder kontinuierlich aus der Anschmelzzone heraus bewegt wird und dabei einen Verbundformkörper bildet, welcher in einem nachgeschalteten Prozeßschritt in an sich bekannter Weise zum Aufschmelzen gebracht wird.

2. Verfahren nach Anspruch 1, dadurch gekennzeichnet, daß in der Anschmelzzone ein Vakuum von mindestens $10^{-2}$ mbar eingestellt wird.

3. Verfahren nach den Ansprüchen 1 und 2, dadurch gekennzeichnet, daß Granulatkörner mit einer Korngröße von 1—50 mm eingesetzt werden.

4. Verfahren nach einem oder mehreren der Ansprüche 1—3, dadurch gekennzeichnet, daß den jeweils zuchargierten Granulatkörnern in der Anschmelzzone eine Energiemenge zugeführt wird, die 20—60% der zu ihrem vollständigen Aufschmelzen benötigten Energiemenge entspricht.

5. Verfahren nach einem oder mehreren der Ansprüche 1—4, dadurch gekennzeichnet, daß der Verbundformkörper auf eine gegenüber der Schüttdichte des vorgelegten Granulates um mindestens 20% erhöhte, höchstens 80% der Dichte von massivem Silicium betragende Dichte gebracht wird.

6. Verfahren nach einem oder mehreren der Ansprüche 1—5, dadurch gekennzeichnet, daß der Verbundformkörper schichtweise bis zur gewünschten Dicke aufgebaut wird.

7. Verfahren nach einem oder mehreren der Ansprüche 1—6, dadurch gekennzeichnet, daß die Energie vermittels Strahlung eingebracht wird.

8. Verfahren nach einem oder mehreren der Ansprüche 1—7, dadurch gekennzeichnet, daß die Energie vermittels Elektronen Strahlung gebracht wird.

## Revendications

1. Procédé pour fabriquer, à partir de silicium en granulés, des objets moulés destinés à la production de masses fondues de silicium, procédé caractérisé en ce qu'on fait subir un début de fusion superficielle, par apport d'énergie, à des granulés mis en contact les uns avec les autres et introduits dans une zone de fusion amorcé et on les réunit de manière à en faire un matériau aggloméré, qui est extrait, en cadence ou en continu, de la zone de fusion amorcée et qui forme ainsi un objet moulé aggloméré, lequel est amené à la fusion, de manière connue, dans une étape opératoire ultérieure.

2. Procédé selon la revendication 1 caractérisé en ce qu'on fait régner, dans la zone de fusion amorcée, un vide d'au moins $10^{-2}$ mbar.

3. Procédé selon les revendications 1 et 2, caractérisé en ce qu'on utilise des granulés dont la dimension particulaire (granularité) est comprise entre 1 et 50 mm.

4. Procédé selon une ou plusieurs des revendications 1 à 3, caractérisé en ce qu'on fournit, aux granulés chargés à chaque fois, dans la zone de fusion amorcée, une quantité d'énergie représentant de 20 à 60% de la quantité d'énergie nécessaire pour les faire fondre totalement.

5. Procédé selon une ou plusieurs des revendications 1 à 4, caractérisé en ce que l'objet moulé aggloméré est amané à une masse volumique qui est augmentée d'au moins 20% par rapport à la masse volumique apparente du produit granulé mis en jeu et au plus égale à 80% de la masse volumique du silicium massif.

6. Procédé selon une ou plusieurs des revendications 1 à 5, caractérisé en ce que l'objet moulé aggloméré est édifié par couche jusqu'à l'épaisseur voulue.

7. Procédé selon une ou plusieurs des revendications 1 à 6, caractérisé en ce que l'énergie est fournie au moyen d'un rayonnament.

8. Procédé selon une ou plusieurs des revendications 1 à 7, caractérisé en ce que l'énergie est fournie au moyen d'un rayonnement électronique.

## Claims

1. Process for the manufacture of shaped bodies from silicon granules for the production of silicon melts, characterized in that granulated grains, charged to an incipient fusion zone and brought into mutual contact, are incipiently fused superficially by supplying energy and joined to give a composite material which is moved cyclically or continuously out of the incipient fusion zone and thus forms a composite shaped body which is caused to fuse in a manner known per se in a downstream process step.

2. Process according to Claim 1, characterized in that a vacuum of at least $10^{-2}$ mbar is set in the incipient fusion zone.

3. Process according to Claims 1 and 2, characterized in that the granulated grains are used at a grain size of 1—50 mm.

4. Process according to one or more or Claims 1—3, characterized in that the granulated grains in the particular charge are supplied in the incipient fusion zone with a quantity of energy corresponding to 20—60% of the quantity of energy required for the complete fusion thereof.

5. Process according to one or more of Claims 1—4, characterized in that the composite shaped body is brought to a density which is increased by at least 20% as compared with the bulk density of the granules introduced and amounts to at most 80% of the density of solid silicon.

6. Process according to one or more of Claims 1—5, characterized in that the composite shaped body is built up in layers up to the desired thickness.

7. Process according to one or more of Claims 1—6, characterized in that the energy is introduced by means of radiation.

8. Process according to one of more of Claims 1—7, characterized in that the energy is introduced by means of electron beams.

Fig. 1

Fig. 2

EP 0 203 518 B1

2